# EUROPEAN PATENT APPLICATION

(11) **EP 4 657 510 A1**
(43) Date of publication of application: **03.12.2025**
(21) Application number: 23901744.5
(22) Date of filing: 24.02.2023
(51) Int. Cl.: H01L 21/67, H01L 21/68, H01L 21/66, H01L 21/687

(54) **SUBSTRATE PROCESSING DEVICE, AND SUBSTRATE INSPECTION METHOD IN LOAD LOCK CHAMBER**

(30) Priority: 25.01.2023 KR 20230009677
(71) Applicant: PSK Inc., Hwaseong-si, Gyeonggi-do 18849 (KR)
(72) Inventor: KIM, Man Jin, Hwaseong-si, Gyeonggi-do 18449 (KR); KIM, Da In, Hwaseong-si, Gyeonggi-do 18449 (KR)
(74) Representative: HGF
(86) International application number: PCT/KR2023/002675
(87) International publication number: WO 2024/158081

(57) **Abstract**

Provided is an apparatus for treating a substrate, the apparatus including: an equipment front end module including a first transfer robot for transferring a substrate; a transfer chamber including a second transfer robot for transferring a substrate; and a load lock chamber disposed on a transfer path along which a substrate is transferred between the transfer frame and the transfer chamber, in which the load lock chamber includes: a housing including an upper chamber having an upper space, and a lower chamber positioned below the upper chamber and having a lower space; a first rotational supporter for supporting and rotating a substrate located in the upper space; and a second rotational supporter for supporting and rotating a substrate located in the lower space, and the first rotational supporter and the second rotational supporter are used for both an alignment inspection of a substrate and a vision inspection of a substrate.

## Description

### Technical Field

The present invention relates to an apparatus for treating substrate, and a substrate inspection method in a load lock chamber.

### Background Art

A device that processes a substrate by using plasma may be utilized to remove a film on the substrate (for example, a hard mask formed on the substrate, or a photoresist film formed on the substrate). An apparatus for treating a substrate by using plasma operates in a process chamber. In order to properly treat a substrate in the process chamber, a notch direction of the substrate entering the process chamber needs to match a preset direction, and a position where the substrate is placed needs to match a preset position. Therefore, the substrate is notch aligned in an alignment chamber before being transferred to the process chamber and then transferred to the process chamber. In addition, the substrate that has been processed in the process chamber is subject to a vision inspection in a vision chamber.

However, as described above, when the substrate is transferred to the alignment chamber, the notch of the substrate is aligned in the alignment chamber, and the substrate is transferred from the alignment chamber to the process chamber, the transfer sequence is complex and the time required for transfer increases.

In addition, when the treated substrate is transferred to the inspection chamber and the inspection chamber checks the treatment status of the substrate as described above, the transfer sequence is complicated and the time required for transfer increases.

On the other hand, the notch of the substrate may be aligned or the status of the substrate may be inspected on the transfer path. For example, the notch of the substrate may be aligned or the status of the substrate may be inspected in a load lock chamber where the substrate waits a second before or after treating. In this case, the load lock chamber needs be equipped with an alignment unit to align the notch of the substrate and an inspection unit to inspect the surface condition of the edge of the substrate, increasing the structural complexity of the load lock chamber.

In particular, the alignment unit is installed on a loading load lock where the substrate is transferred to the process chamber, and the inspection unit is installed on an unloading load lock where the substrate is unloaded from the process chamber. Therefore, since the substrates are transferred one by one and the movement path is fixed, the Unit Per Equipment Hour (UPEH) decreases.

### Technical Problem

The present invention aims to provide a substrate treating apparatus including a rotating body usable for both an alignment inspection and a vision inspection, and a substrate inspection method in a load lock chamber.

The present invention aims to provide a substrate treating apparatus capable of reducing the time required for aligning a notch of a substrate and inspecting a treatment status of the substrate, and a substrate inspection method in a load lock chamber.

The present invention aims to provide a substrate treating apparatus capable of maximize Unit Production Per Hour (UPEH) efficiency, and a substrate inspection method in a load lock chamber.

The present invention aims to provide a substrate treating apparatus capable of performing alignment and vision inspection in two chambers, and a substrate inspection method in a load lock chamber.

The problem to be solved by the present invention is not limited to the above-mentioned problems, and the problems not mentioned will be clearly understood by those skilled in the art from the present specification and the accompanying drawings.

### Technical Solution

One aspect of the present invention provides an apparatus for treating a substrate, the apparatus including: an equipment front end module including a first transfer robot for transferring a substrate;
a transfer chamber including a second transfer robot for transferring a substrate; and a load lock chamber disposed on a transfer path along which a substrate is transferred between the transfer frame and the transfer chamber, in which the load lock chamber includes: a housing including an upper chamber having an upper space, and a lower chamber positioned below the upper chamber and having a lower space; a first rotational supporter for supporting and rotating a substrate located in the upper space; and a second rotational supporter for supporting and rotating a substrate located in the lower space, and the first rotational supporter and the second rotational supporter are used for both an alignment inspection of a substrate and a vision inspection of a substrate.

Further, the apparatus may further include: a first stationary supporter for supporting the substrate in the upper space; and a second stationary supporter for supporting the substrate in the lower space, in which the first rotational supporter may be rotated by a first rotation driving part and lifted by a first lifting driving part, the second rotational supporter may be rotated by a second rotation driving part, and the second stationary supporter may be lifted by a second lifting driving part.

Further, the first stationary supporter may include: first support shafts provided at an edge of the upper space; and first edge slots connected to each of the first support axes, respectively, and supporting a lower edge of the substrate, and the apparatus may further include a third rotation driving part for pivoting the first support shafts such that the first edge slots are pivoted from a position capable of supporting the substrate to an avoidance position having no interference during rotating and lifting operations of the first rotational supporter.

Further, the second stationary supporter may include: second support shafts provided at an edge of the lower space; and second edge slots connected to the second support shafts, respectively, and supporting a lower edge of the substrate.

Further, the first rotational supporter may include: a first rotation shaft connected with the first rotation driving part provided above the housing; horizontal fingers provided in the upper space, connected with the first rotation shaft, and having lengths greater than a radius of the substrate; and support fingers provided at distal ends of the horizontal fingers and supporting a lower edge of the substrate.

Further, the first lifting driving part may include: a first actuator; a first lifting bar lifted by the first actuator and connected with the first rotational supporter; and a first guide for guiding upward and downward movement of the first lifting bar.

Further, the second rotational supporter may include: a second rotation shaft connected with the second rotation driving part provided in a lower portion of the housing; and a support plate provided in the lower space, connected to the second rotation shaft, smaller than a radius of the substrate, and supporting a center portion of a bottom surface of the substrate.

Further, the apparatus may further include a third stationary supporter provided at a floor surface of the upper space, and supporting the substrate, in which the substrate may be picked up and placed on the third stationary supporter by an up/down operation of the first rotational supporter.

Further, a center of rotation of the first rotational supporter and a center of rotation of the second rotational supporter may be provided to be different, an alignment inspection and vision inspection position in the first rotational supporter and an alignment inspection and vision inspection position in the second rotational supporter may be provided positions where the substrate placed on the first rotational supporter and the substrate placed on the second rotational supporter do not overlap each other when viewed from above.

Further, the apparatus may further include: a first alignment unit for aligning a substrate located in the upper space; a second alignment unit for aligning a substrate located in the lower space; a first vision unit for inspecting an edge surface condition of a substrate located in the upper space; and a second vision unit for inspecting an edge surface condition of a substrate located in the lower space.

Further, the first alignment unit, the second alignment unit, the first vision unit, and the second vision unit may be provided above the housing.

Further, a partition wall between the upper chamber and the lower chamber may be provided with a viewing window for the alignment inspection and the vision inspection of the substrate located in the lower space.

Another aspect of the present invention provides a method of inspecting a substrate in a load lock chamber located between an equipment front end module and a transfer chamber, the method including: a first loading operation in which a pre-treatment substrate is loaded from the equipment front end module and a post-treatment substrate is unloaded to the equipment front end module; a second loading operation in which a post-treatment substrate is loaded from the transfer chamber and the pre-treatment substrate is unloaded to the transfer chamber; an alignment inspection operation in which an alignment inspection of the pre-treatment substrate is performed prior to the second loading operation; and a vision inspection operation in which a vision inspection of the post-treatment substrate is performed prior to the first loading operation, in which the alignment inspection operation and the vision inspection operation are performed in a state where the pre-treatment substrate and the post-treatment substrate are placed on the same rotational supporter.

Further, the post-treatment substrate after the vision inspection on the rotational supporter may be placed on a stationary supporter, the pre-treatment substrate may be placed on the rotational supporter in the first loading operation, the pre-treatment substrate placed on the stationary supporter may be placed on the rotational supporter and then subjected to the alignment inspection in the alignment inspection operation.

Further, the post-treatment substrate may be placed on the stationary supporter in the second loading operation, and the post-treatment substrate placed on the stationary supporter may be placed on the rotational supporter and subjected to the vision inspection in the vision inspection operation.

Further, the alignment inspection operation may include performing an origin operation to pivot the rotational supporter to an origin position after finishing the alignment of the pre-treatment substrate, and the origin operation of the rotational supporter may be accomplished after the pretreatment substrate is placed on a stationary supporter installed on a floor of an interior space of the load lock chamber.

Further, during the alignment inspection operation, an internal pressure of the load lock chamber may be switched from normal pressure to a preset vacuum pressure, and during the vision inspection operation, the internal pressure of the load lock chamber may be switched from the preset vacuum pressure to the normal pressure.

Another aspect of the present invention provides an apparatus for treating a substrate, the apparatus including: a housing including an upper chamber having an upper space, and a lower chamber positioned below the upper chamber and having a lower space; a first rotational supporter for supporting and rotating a substrate located in the upper space; a second rotational supporter for supporting and rotating a substrate located in the lower space; a first stationary supporter for supporting a substrate in the upper space; a second stationary supporter for supporting a substrate in the lower space; a first alignment unit for aligning a substrate located in the upper space; a second alignment unit for aligning a substrate located in the lower space; a first vision unit for vision-inspecting a substrate located in the upper space; and a second vision unit for vision-inspecting a substrate located in the lower space, in which the first alignment unit, the second alignment unit, the first vision unit, and the second vision unit are provided above the housing, and the first rotational supporter and the second rotational supporter are used for both an alignment inspection of the substrate and a vision inspection of the substrate.

Further, the first rotational supporter may be rotated by a first rotation driving part and lifted by a first lifting driving part, the second rotational supporter may be rotated by a second rotation driving part, and the second stationary supporter may be lifted by a second lifting driving part, and the first stationary supporter may include: first support shafts provided at an edge of the upper space; and first edge slots connected to each of the first support axes, respectively, and supporting a lower edge of the substrate, and the apparatus may further include: a third rotation driving part for pivoting the first support shafts such that the first edge slots are pivoted from a position capable of supporting the substrate to an avoidance position having no interference during rotating and lifting operations of the first rotational supporter; and a second stationary supporter provided on a floor surface of the upper space and supporting the substrate, and the substrate may be picked up and placed on the second stationary supporter by an up/down operation of the first rotational supporter.

Further, a center of rotation of the first rotational supporter and a center of rotation of the second rotational supporter may be provided to be different, an alignment inspection and vision inspection position in the first rotational supporter and an alignment inspection and vision inspection position in the second rotational supporter may be provided at positions where the substrate placed on the first rotational supporter and the substrate placed on the second rotational supporter do not overlap each other when viewed from above, and a partition wall between the upper chamber and the lower chamber may be provided with a viewing window for the second alignment unit and the second vision unit.

### Advantageous Effects

According to the exemplary embodiment of the present invention, notch alignment (alignment inspection) of a substrate and a vision inspection to check a surface condition of an edge of a substrate may be performed in a single rotational supporter.

According to the exemplary embodiment of the present invention, by performing notch alignment and vision inspection in each of the upper chamber and the lower chamber, a layout may be reduced and additional transfer time of the transfer robot may be saved.

According to the exemplary embodiment of the present invention, notch alignment and vision inspection in each of the upper chamber and the lower chamber may be performed during chamber pumping time and chamber purge time, thereby maximizing Unit Production Per Hour (UPEH) efficiency.

According to the exemplary embodiment of the present invention, notch alignment and vision inspection may be selectively performed in each of the upper chamber and the lower chamber.

The effect of the present invention is not limited to the foregoing effects, and the not-mentioned effects will be clearly understood by those skilled in the art from the present specification and the accompanying drawings.

### Description of Drawings

FIG. 1 is a diagram schematically illustrating a substrate treating apparatus according to an exemplary embodiment of the present invention.
FIG. 2 is a diagram schematically illustrating an exemplary embodiment of a load lock chamber of FIG. 1.
FIG. 3A is a top plan view of the load lock chamber of FIG. 2.
FIG. 3B is a cross-sectional view cut along the A-A line indicated in FIG. 3A.
FIG. 4 is a diagram illustrating a lower chamber.
FIG. 5 is a diagram illustrating an upper chamber.
FIG. 6 is a cross-sectional view taken along the B-B line illustrated in FIG. 5.
FIGS. 7A to 7F are diagrams illustrating a step-by-step process of a substrate inspection in the lower chamber.
FIG. 8 is a flowchart illustrating a step-by-step process of a substrate inspection in the lower chamber.
FIGS. 9A to 9H are diagrams illustrating a step-by-step process of a substrate inspection in an upper chamber.
FIG. 10 is a flowchart illustrating a step-by-step process of substrate inspection in the upper chamber.
FIGS. 11A and 11B are drawings for illustrating an origin operation of a first rotational supporter.

### Best Mode

Hereinafter, an exemplary embodiment of the present invention will be described in more detail with reference to the accompanying drawings. An exemplary embodiment of the present invention may be modified in various forms, and the scope of the present invention should not be construed as being limited by the exemplary embodiment described below. The present exemplary embodiment is provided to more completely explain the present invention to those skilled in the art. Therefore, the shapes of components in the drawings are exaggerated to emphasize a clearer description.

Terms, such as first and second, are used for describing various constituent elements, but the constituent elements are not limited by the terms. The terms are used only to discriminate one constituent element from another constituent element. For example, without departing from the scope of the invention, a first constituent element may be named as a second constituent element, and similarly a second constituent element may be named as a first constituent element.

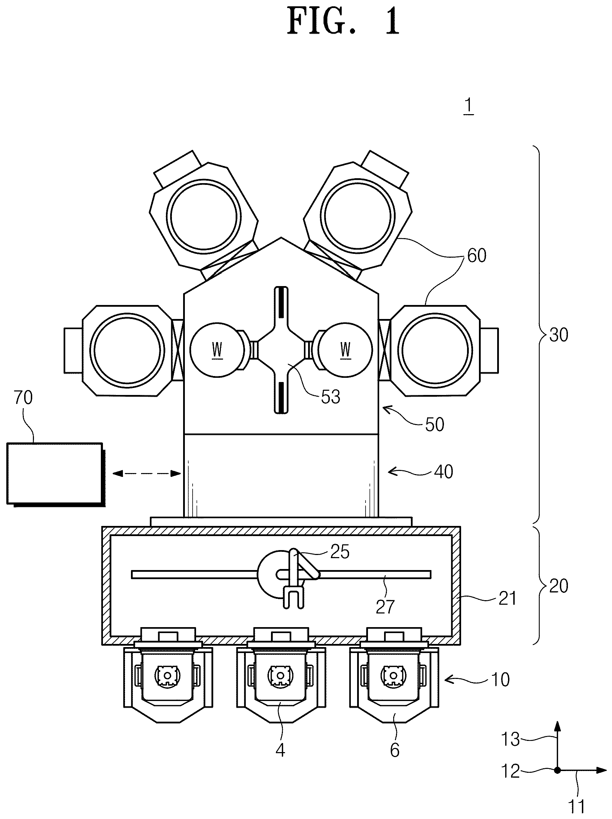

Hereinafter, an exemplary embodiment of the present invention will be described in detail with reference to FIGS. 1 to 11B.

FIG. 1 is a diagram schematically illustrating a substrate treating apparatus according to an exemplary embodiment of the present invention. Referring to FIG. 1, a substrate treating apparatus 1 includes an Equipment Front End Module (EFEM) 20 and a processing module 30. The EFEM 20 and the processing module 30 are disposed in one direction.

The EFEM 20 includes a load port 10 and a transfer frame 21. The load port 10 includes a plurality of support parts 6. The plurality of support parts 6 may be arranged in a row in a first direction 11. When viewed from the front, a direction perpendicular to the first direction 11 is defined as a second direction 12. For example, the second direction 12 may be a direction perpendicular to the ground. The direction perpendicular to the plane including both the first direction 11 and the second direction 12 is defined as a third direction 13.

On each support part 6, a container 4 may be rested. According to the exemplary embodiment, the container 4 may include a cassette, a FOUP, or the like. In the container 4, the substrate W to be provided to the process and the substrate W that has been completely processed is accommodated.

The transfer frame 21 is disposed between the load port 10 and the processing module 30. The interior space of the transfer frame 21 may be maintained in a largely atmospheric atmosphere. A first transfer robot 25 is disposed in the interior of the transfer frame 21. The first transfer robot 25 transfers the substrate W between the load port 10 and the processing module 30. The first transfer robot 25 may move along the transfer rail 27 provided in the first direction 11 to transfer the substrate W between the container 4 and the processing module 30.

The processing module 30 includes a load lock chamber 40, a transfer chamber 50, and a process chamber 60. The processing module 30 may receive the substrate W accommodated in the container 4 placed at the load port 10 and perform a treatment process to remove a thin film from an edge region of the substrate W.

The load lock chamber 40 is disposed adjacent to the transfer frame 21. For example, the load lock chamber 40 may be disposed between the EFEM 20 and the transfer chamber 50. The load lock chamber 40 provides a waiting space for the substrate W to be provided to the process before the substrate W is transferred to the process chamber 60, or for the substrate W that has completed process treatment before the substrate W is transferred to the EFEM 20. The internal atmosphere of the load lock chamber 40 may be switched between an atmospheric pressure atmosphere and a vacuum pressure atmosphere. A detailed description of the load lock chamber 40 will be provided later.

The transfer chamber 50 transfers the substrate W. For example, the transfer chamber 50 may transfer the substrate W between the load lock chamber 40 and the process chamber 60. The transfer chamber 50 is disposed to be adjacent to the load lock chamber 40. The transfer chamber 50 may have a polygonal body when viewed from the top. On the outer side of the body, the load lock chamber 40 and a plurality of process chambers 60 may be disposed along the circumference of the body.

The internal atmosphere of the transfer chamber 50 may be maintained as a largely vacuum pressure atmosphere. In the interior space of the transfer chamber 50, a second transfer robot 53 is disposed for transferring the substrate W between the load lock chamber 40 and the process chambers 60. The second transfer robot 53 transfers the unprocessed substrate W waiting in the load lock chamber 40 to the process chamber 60, or transfers the completely processed substrate W from the process chamber 60 to the load lock chamber 40. Further, the second transfer robot 53 may transfer the substrate W between the plurality of process chambers 60.

The process chamber 60 is disposed adjacent to the transfer chamber 50. The process chamber 60 may be disposed along a perimeter of the transfer chamber 50. A plurality of process chambers 60 may be provided. In each process chamber 60, a process treatment for the substrate W is performed. The process chamber 60 receives the substrate W from the second transfer robot 53, performs the process treatment on the substrate W, and delivers the completely processed substrate W to the second transfer robot 53. The process treatment performed in each of the process chambers 60 may differ from each other.

The controller 70 may control the substrate treating apparatus 1. The controller 70 may control each of the configurations that the substrate treating apparatus 1 includes so as to perform the substrate treating method described below. The controller 70 may control the operation of the substrate treating apparatus 1. The controller 70 may include a Central Processing Unit (CPU), Read Only Memory (ROM), Random Access Memory (RAM), or the like.

In the following, the process chambers 60 may be process chambers 60 that treat a substrate with plasma. The process chamber 60 performing the plasma treatment process may etch or ash a film on the edge of the substrate W. The film may include various types of films, such as polysilicon films, oxide films, and silicon nitride films.

In one example, the process chamber 60 of the substrate treating apparatus 1 may perform a bevel etch process to remove a film on an edge region of the substrate W. However, without being limited thereto, the process chambers 60 of the substrate treating apparatus 1 may be various process chambers 60 in which the treatment of the substrate W is performed.

Hereinafter, the load lock chamber 40 according to the exemplary embodiment of the present invention will be described in detail.

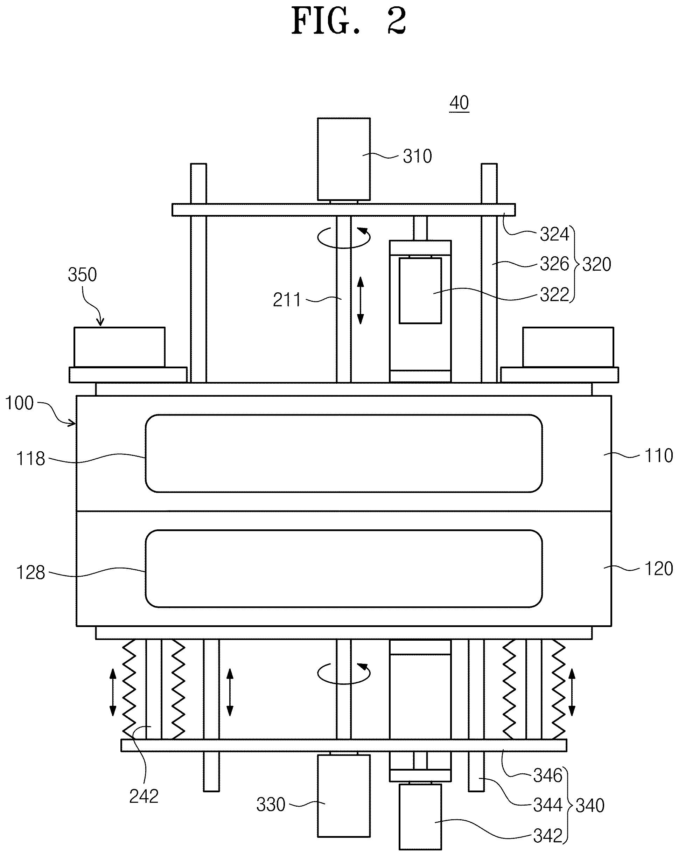

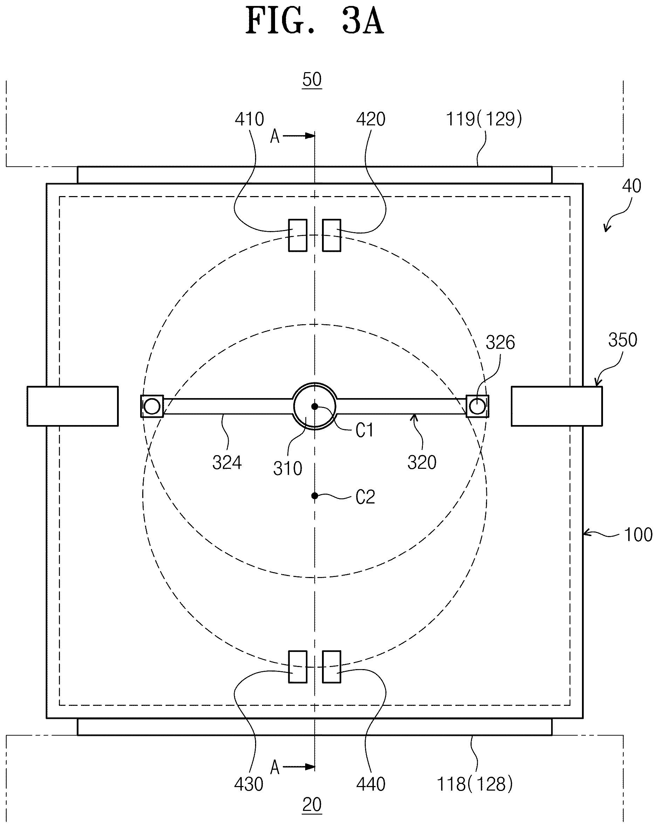

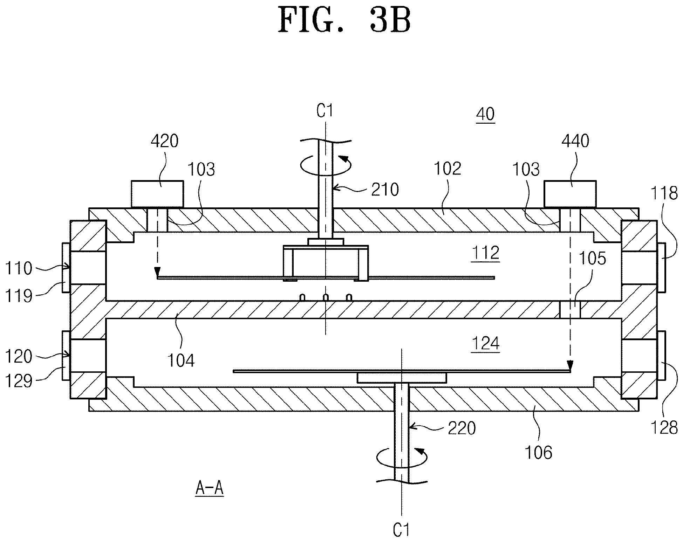

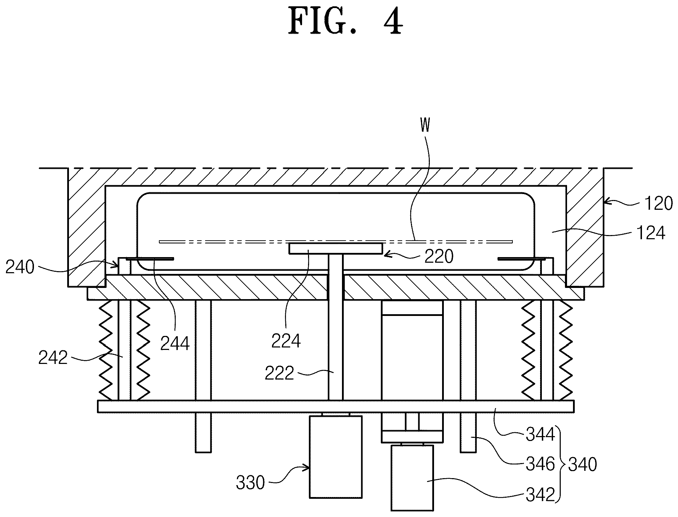

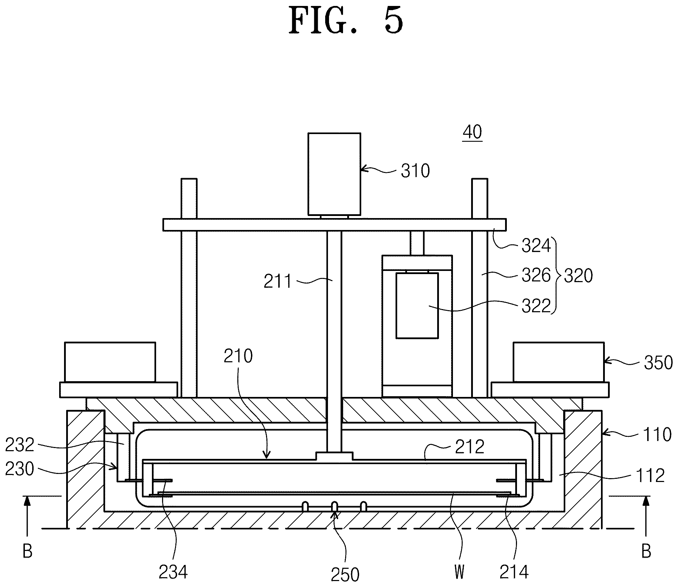

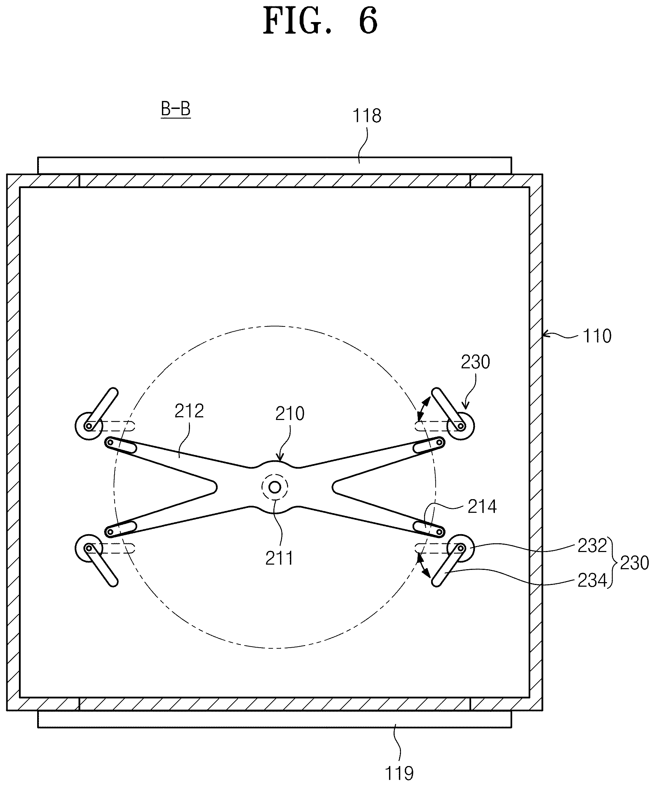

FIG. 2 is a diagram schematically illustrating an exemplary embodiment of the load lock chamber of FIG. 1, FIG. 3A is a top plan view of the load lock chamber of FIG. 2, and FIG. 3B is a cross-sectional view cut along the A-A line indicated in FIG. 3A. FIG. 4 is a diagram illustrating a lower chamber, and FIG. 5 is a diagram illustrating an upper chamber. FIG. 6 is a cross-sectional view taken along the B-B line illustrated in FIG. 5.

Referring to FIGS. 2 to 6, the load lock chamber 40 may include a housing 100, a first rotational supporter 210, a first stationary supporter 230, a second rotational supporter 220, a second stationary supporter 240, a first rotation driving part 310, a first lifting driving part 320, a second rotation driving part 330, a second lifting driving part 340, a third rotation driving part 350, and a third stationary supporter 250.

The invention is characterized in that the first rotational supporter 210 and the second rotational supporter 220 are used jointly for aligning the notches of the substrate (alignment inspection) and for inspecting the surface condition of the edges of the substrate (vision inspection).

The housing 100 includes an upper chamber 110 and a lower chamber 120, and the upper chamber 110 and the lower chamber 120 are disposed while being stacked each other. The upper chamber 110 has an upper space 112, and the lower chamber 120 has a lower space 124. A partition wall 104 is provided between the upper space 112 and the lower space 124. The upper space 112 and the lower space 124 may be switched between a vacuum pressure atmosphere and an atmospheric pressure atmosphere by an atmosphere switching unit (not shown).

First gate doors 118 and 128 are provided in a first side wall of the housing 100. When the first gate doors 118 and 128 are opened, the interior space of the transfer frame 21 and the upper space 112 and the lower space 124 may be communicated.

Second gate doors 119 and 129 are provided on a second sidewall of the housing 100. When the second gate doors 119 and 129 are opened, the inner space of the transfer chamber 50 and the upper space 112 and the lower space 124 may be communicated.

The internal atmospheres of the upper space 112 and the lower space 124 may be independently switched between an atmospheric pressure atmosphere and a vacuum pressure atmosphere by an atmosphere switching unit (not shown). The upper space 112 and the lower space 124 may function as a space where a substrate scheduled for treatment (hereinafter referred to as a pre-treatment substrate W) is loaded in. For example, the upper space 112 and the lower space 124 may function as a space for receiving the substrate W that has been unloaded from the container 4 placed at the load port 10 illustrated in FIG. 1. The substrate W unloaded from the container 4 may be the substrate W scheduled for process treatment in the process chamber 60 illustrated in FIG. 1.

Furthermore, the upper space 112 and the lower space 124 may function as a space where the completely processed substrate (the post-treatment substrate W) is loaded in. For example, the upper space 112 and the lower space 124 may function as a space for receiving the substrate W that has completed the bevel etch process in the process chamber 60 illustrated in FIG. 1. The substrate W unloaded from the process chamber 60 may be the substrate W to be received into the container 4 illustrated in FIG. 1.

The first rotational supporter 210 supports and rotates the substrate W located in the upper space 112. The first rotational supporter 210 may be rotated by the first rotation driving part 310 and lifted by the first lifting driving part 320. The first rotational supporter 210 may include a first rotation shaft 211, horizontal fingers 212, and support fingers 214. The first rotation shaft 211 is connected to the first rotation driving part 310 provided on the top of the housing 100. The horizontal fingers 212 are provided in the upper space 112 and are connected to the first rotation shaft 211. The horizontal fingers 212 have a length greater than the substrate radius. The support fingers 214 are provided at the ends of the horizontal fingers 212. The support fingers 214 support the bottom edge of the substrate W. In the present exemplary embodiment, the first rotational supporter 210 is illustrated to support the substrate W at four points, but is not limited to.

The first rotation driving part 310 is coupled to the first rotation shaft 211. The first rotation driving part 310 provides driving force to the first rotation shaft 211. According to the exemplary embodiment, the first rotation driving part 310 may be a motor that provides the driving force.

The first lifting driving part 320 may include a first actuator 322, a first lifting bar 324, and a first guide 326. The first actuator 322 may be a hydraulic cylinder. The first actuator 322 may be installed on the top wall 102 of the housing 100. The first lifting bar 324 may be lifted by the first actuator 322. The first lifting bar 324 may be connected to the first rotational supporter 210. The first guide 326 is provided to guide the up and down movement of the first lifting bar 324.

The first stationary supporter 230 is provided to support the substrate W in the upper space 112. The first stationary supporter 230 may include four first support shafts 233 provided at the edges of the upper space 112, and first edge slots 234 connected to the first support shafts 232, respectively, and supporting the bottom edge of the substrate. The first support shaft 232 may be rotated by a third rotation driving part 350. The rotation of the first support shaft 232 may cause the first edge slots 234 to be pivoted to a regular position or an avoidance position. The regular position may be a position where the first edge slots 234 may support the substrate. The avoidance position may be a position where the first edge slots 234 do not interfere with the rotation and lifting operation of the first rotational supporter 210. For reference, the regular position of the first edge slot 234 is shown as a dashed line in FIG. 6, and the avoidance position of the first edge slot 234 is shown as a solid line in FIG. 6. In the present exemplary embodiment, the first stationary supporter 230 is described as supporting the substrate at four points, but is not limited thereto.

The third stationary supporter 250 may be provided in the form of a pin protruding from a floor surface of the upper space 112. At least three third fixed supports 250 may be provided to support the substrate W. The substrate may be picked up/placed on the third stationary supporter 250 by an up/down operation of the first rotational supporter 210.

The second rotational supporter 220 supports and rotates the substrate located in the lower space 124. The second rotational supporter 220 may be rotated by the second rotation driving part 330. In one example, the second rotational supporter 220 may include a second rotation shaft 222 and a support plate 224. The second rotation shaft 222 is provided in a lower portion of the housing 100. The support plate 224 is connected to the second rotation shaft 222. When viewed from the top, the support plate 224 may have a relatively smaller diameter than the substrate W. The support plate 224 is provided to support a lower center portion of the substrate.

The second rotation driving part 330 is coupled to the second rotation shaft 222. The second rotation driving part 330 provides driving force to the second rotation shaft 222. According to the exemplary embodiment, the second rotation driving part 330 may be a motor that provides the driving force.

The second stationary supporter 240 may be provided to support the substrate W in the lower space. The second stationary supporter 240 may be lifted by the second lifting driving part 340. The second stationary supporter 240 may include four second support shafts 242 provided at the edges of the lower space, and second edge slots 244 connected to the second support shafts 242, respectively, and supporting the lower edge of the substrate.

The second lifting driving part 340 may include a second actuator 342, a second lifting bar 344, and a second guide 346. The second actuator 342 may be a hydraulic cylinder. The second actuator 342 may be installed on the lower wall 106 of the housing 100. The second lifting bar 344 may be lifted by the second actuator 342. The second lifting bar 344 may be connected to the second rotational supporter 220. The second guide 346 is provided to guide the up and down movement of the second lifting bar 344.

On top of the housing 100, a first alignment unit 410, a second alignment unit 430, a first vision unit 420, and a second vision unit 440 are installed. The first alignment unit 410 and the first vision unit 420 detect the substrate located in the upper space 112. The second alignment unit 430 and the second vision unit 440 detect the substrate located in the lower space 124. The detection may include inspecting the alignment of the notches on the substrate and the surface condition of the edges of the substrate. The first alignment unit 410 and the second alignment unit 430 may inspect the notches of the substrate. The first vision unit 420 and the second vision unit 440 may inspect the surface condition of the top edge of the substrate W.

In order for the second alignment unit 430 and the second vision unit 440 to detect the substrate in the lower space 124, the center of rotation C1 of the first rotational supporter 210 and the center of rotation C2 of the second rotational supporter 220 are provided to be different. In other words, an alignment inspection and vision inspection position on the first rotational supporter 210 and an alignment inspection and vision inspection position on the second rotational supporter 220 are provided at positions where the substrate placed on the first rotational supporter 210 and the substrate placed on the second rotational supporter 220 do not overlap each other when viewed from above.

The first alignment unit 410 and the first vision unit 420 are positioned close to the first sidewall of the housing 100 in which the second gate door 119 is installed, and the second alignment unit 430 and the second vision unit 440 are positioned close to the second side wall of the housing 100 in which the first gate door 118 is installed.

The housing 100 may be provided with view ports 103 and 105. For example, first view ports 103 may be provided on a top wall 102 of the housing 100, and a second view port 105 may be provided on the partition wall 104 between the upper chamber and the lower chamber. The first view port 103 and the second view port 105 may be formed of a transparent material.

The first view port 103 may be provided at each of the location adjacent to the first alignment unit 410 and the first vision unit 420 and the location adjacent to the second alignment unit 430 and the second vision unit 440.

The second view port 105 may be provided at a location where the second alignment unit 430 and the second vision unit 440 may detect the substrate in the lower space 124.

Hereinafter, a method of inspecting a substrate in the load lock chamber according to an exemplary embodiment of the present invention will be described. The controller 70 may control the configurations of the load lock chamber 40 to perform the substrate treating method described below.

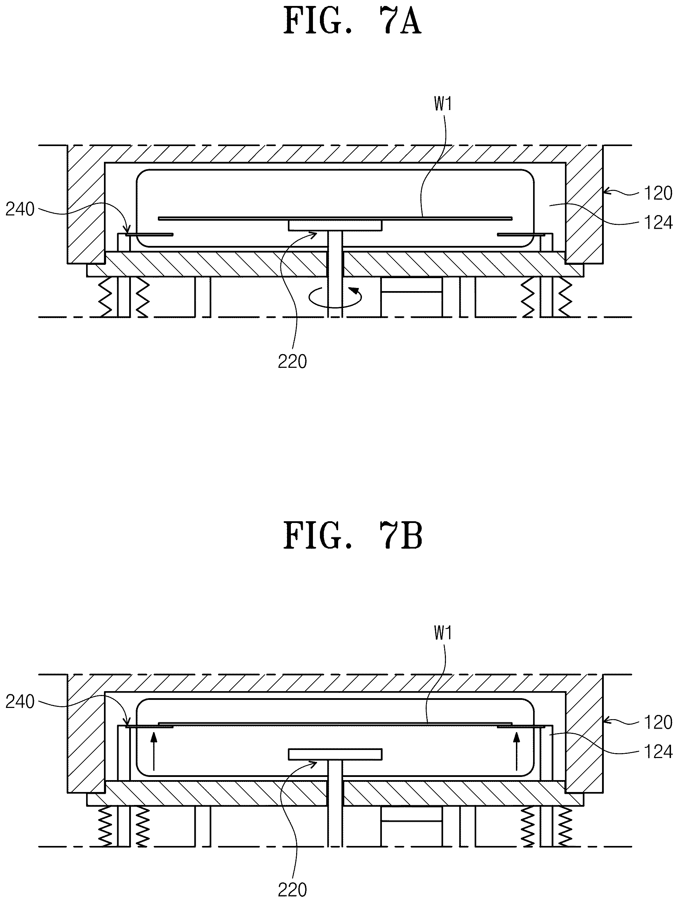

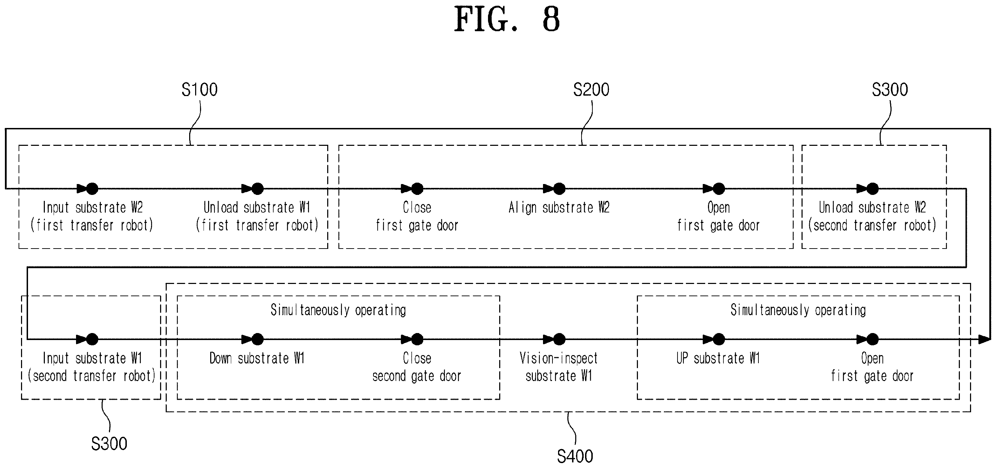

FIGS. 7A to 7F are diagrams illustrating a step-by-step process of a substrate inspection in the lower chamber, and FIG. 8 is a flowchart illustrating a step-by-step process of a substrate inspection in the lower chamber.

Referring to FIGS. 7A to 8, a substrate inspection method in the lower chamber may include a first loading operation S 100, an alignment inspection operation S200, a second loading operation S300, and a vision inspection operation S400. After the vision inspection operation S400, the first receiving operation S100 is performed again.

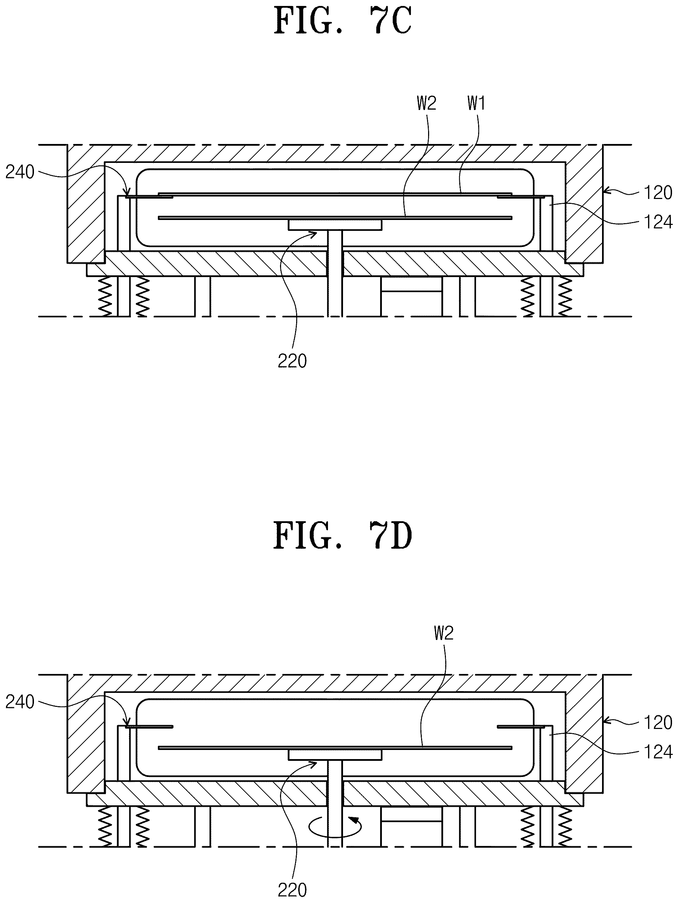

In the first receiving operation S100, a pre-treatment substrate W2 is loaded by the first transfer robot 25 of the EFEM 20, and a post-treatment substrate W1 is unloaded to the EFEM 20 (the state in which the first gate door is open). The pre-treatment substrate W2 is placed on the second rotational supporter 220 (see FIG. 7C). In the first loading operation S100, the post-treatment substrate W1 may be in a state in which the vision inspection has been completed.

In the alignment inspection operation S200, the first gate door 128 is closed, and notch alignment is performed on the substrate W2 before the treatment. That is, the pre-treatment substrate W2 is rotated by the second rotational supporter 220, and the second alignment unit 430 inspects the notches of the substrate W2 (FIG. 7D). When the alignment of the pre-treatment substrate W2 is completed, the second gate door 129 is opened.

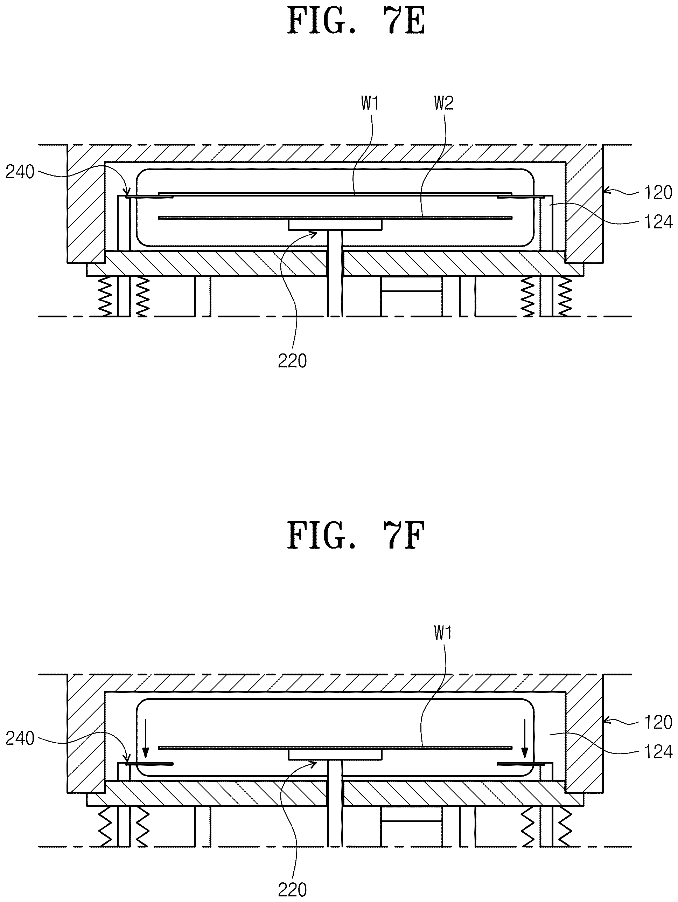

In the second loading operation S300, the post-treatment substrate W1 is loaded by the second transfer robot 53 of the transfer chamber 50, and the pre-treatment substrate W2 is unloaded to the transfer chamber 50 (FIG. 7E). The post-treatment substrate W1 loaded into the lower space 124 by the second transfer robot 53 is placed on the second stationary supporter 220. Since the second transfer robot may be switched during the second loading operation, the order of loading and unloading the pre-treatment substrate and the post-treatment substrate may be changed.

In the vision inspection operation S400, the post-treatment substrate W1 is placed on the second rotational supporter 220 by a lowering operation of the second stationary supporter 240 (FIG. 7F). Then, the second gate door 129 is closed. The post-treatment substrate W1 is rotated by the second rotational supporter 220, and the second vision unit 440 inspects the surface condition of the upper edge of the post-treatment substrate W1 (FIG. 7A). After completing the vision inspection, the post-treatment substrate W1 is placed on the second stationary supporter 240, and the first gate door 128 is opened (FIG. 7B).

As described above, according to the present exemplary embodiment, the alignment inspection operation and the vision inspection operation are performed in the state where the pre-treatment substrate W2 and the post-treatment substrate W1 are placed on the same second rotational supporter 220.

Meanwhile, during the alignment inspection operation, the internal pressure of the lower space 124 may be switched from normal pressure to a preset vacuum pressure, and during the vision inspection operation, the internal pressure of the lower space 124 may be switched from a preset vacuum pressure to normal pressure.

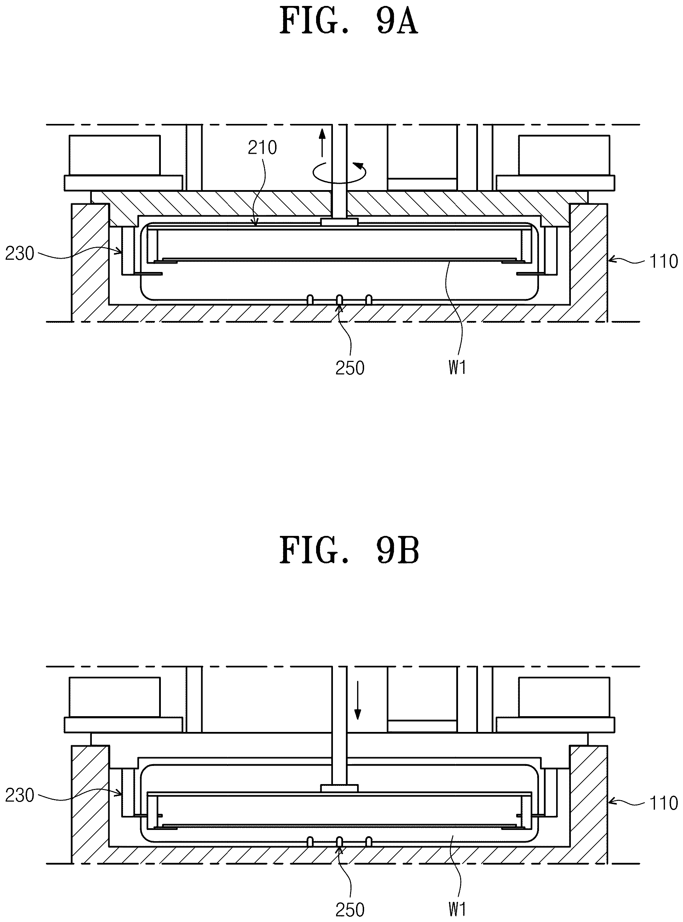

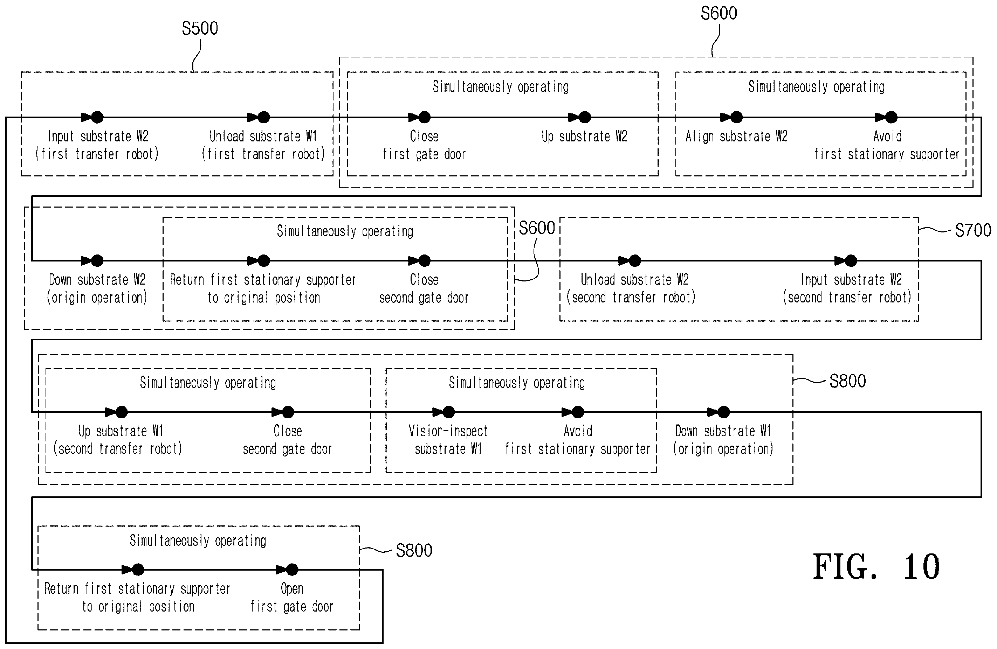

FIGS. 9A to 9H are diagrams illustrating a step-by-step process of a substrate inspection in an upper chamber. FIG. 10 is a flowchart illustrating a step-by-step process of substrate inspection in the upper chamber.

Referring to FIGS. 9A to 10, a substrate inspection method in the upper chamber may include a first loading operation S500, an alignment inspection operation S600, a second loading operation S700, and a vision inspection operation S800. After the vision inspection operation S800, the first loading operation S500 is performed again.

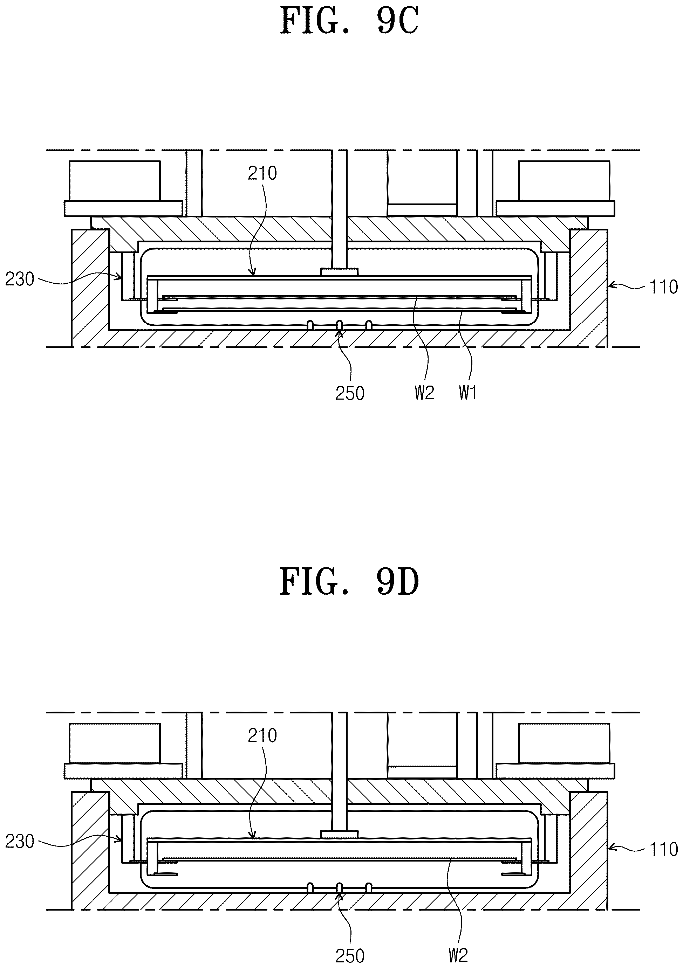

In the first loading operation S500, the pre-treatment substrate W2 is loaded by the first transfer robot 25 of the EFEM 20, and the post-treatment substrate W1 is unloaded to the EFEM 20 (in the state where the first gate door 118 is open). The pre-treatment substrate W2 is placed on the first stationary supporter 230, and the post-treatment substrate W1 placed on the first rotational supporter 210 is unloaded to the EFEM 20 (FIG. 9C and FIG. 9D). In the first loading operation S500, the post-treatment substrate W1 may be in a state in which the vision inspection has been completed.

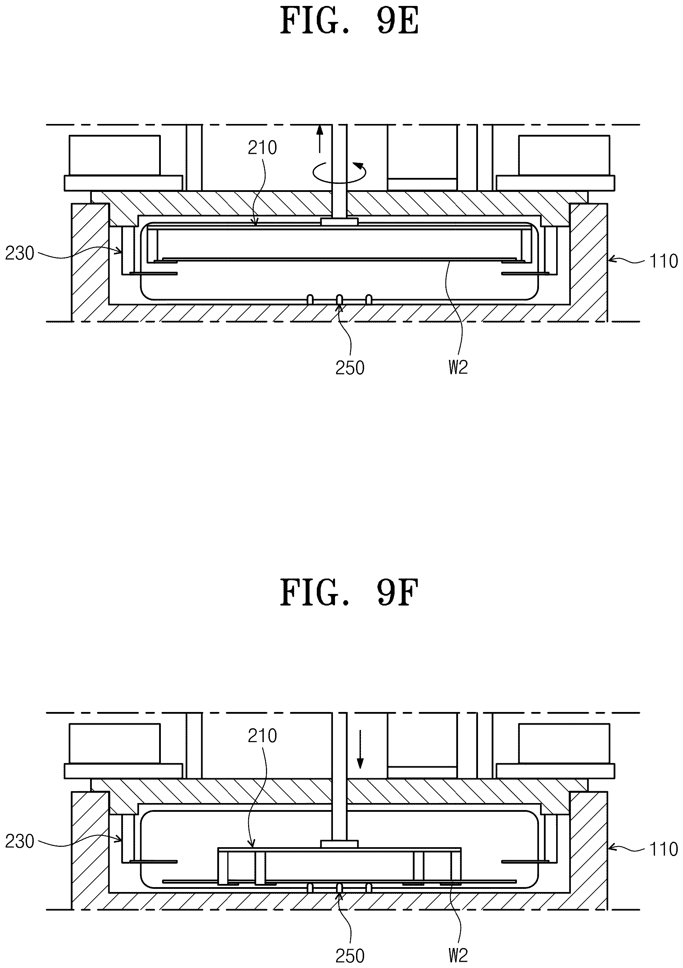

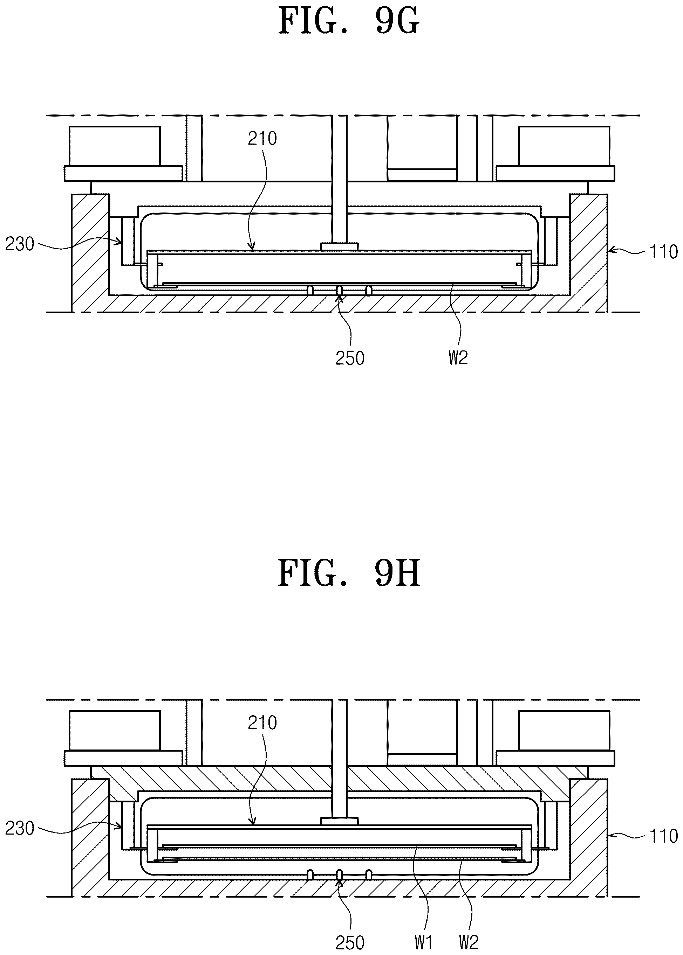

In the alignment inspection operation S600, the first gate door 118 is closed, and the notch alignment for the pre-treatment substrate W2 is performed. The pre-treatment substrate W2 is placed on the first rotational supporter 210 by a lifting operation of the first rotational supporter 210. The pre-treatment substrate W2 is rotated by the first rotational supporter 210, and the first alignment unit 410 inspects the notches of the substrate W2 (FIG. 9E). The first rotational supporter 210 is rotated in the state where the first edge slots 234 of the first stationary supporter 230 are pivoted to the avoidance position. In the alignment inspection, when the notch is located on the support finger 214, the first alignment unit 410 cannot detect the notch. In this case, after the timeout alarm, the substrate W2 is lowered onto the third stationary supporter 250. At this time, the support fingers 214 are lowered further than the substrate, and rotate the first rotational supporter 210 by a certain angle so that the notch avoids the support fingers 214. The alignment inspection is then performed again. When the alignment of the pre-treatment substrate W2 is complete, the positions of the support fingers 214 may not be in the origin positions. In this case, the transfer robot cannot enter. Therefore, an origin operation is performed to pivot the first rotational supporter 210 to the origin position (FIG. 9F and FIG. 9G). In the origin operation of the first rotational supporter 210, the first edge slots 234 of the first stationary supporter 230 wait in the avoidance position. For reference, the origin position of the first rotational supporter 210 is a non-collision position during substrate loading/unloading, and is illustrated in FIG. 6.

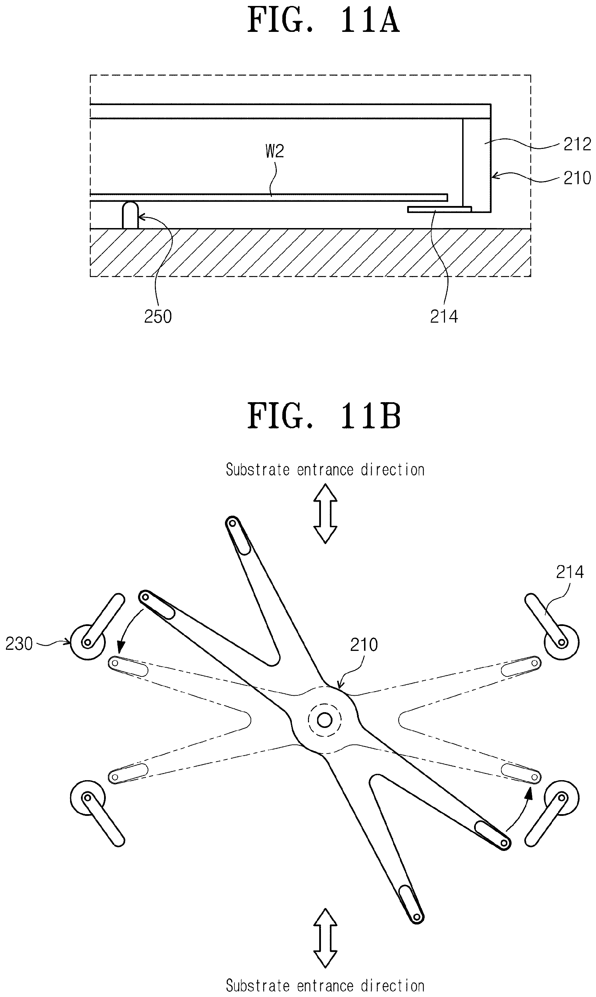

FIGS. 11A and 11B are drawings for illustrating an origin operation of a first rotational supporter. Referring to FIG. 9F, FIG. 9G, FIG. 11A, and FIG. 11B, the origin operation of the first rotational supporter 210 moves the support fingers 214 to the origin position after the pre-treatment substrate W2 is placed on the third stationary supporter 250. When the origin operation of the first rotational supporter 210 is completed, the first edge slots 234 of the first stationary supporter 230 are pivoted from the avoidance position to the regular position, and the second gate door 119 is opened.

In the second loading operation S700, the post-treatment substrate W1 is loaded by the second transfer robot 53 of the transfer chamber 50, and the pre-treatment substrate W2 is unloaded to the transfer chamber 50 (FIG. 9H). The post-treatment substrate W1 loaded into the upper space 112 by the second transfer robot 53 is placed on the first stationary supporter 230.

In the vision inspection operation S800, the post-treatment substrate W1 is placed on the first rotational supporter 210 by a lifting operation of the first rotational supporter 210 (FIG. 9A). Then, the second gate door 119 is closed. The post-treatment substrate W1 is rotated by the first rotational supporter 210, and the first vision unit 420 inspects the surface condition of the upper edge of the post-treatment substrate W1 (FIG. 9A). After completing the vision inspection, the post-treatment substrate W1 is moved to a down position (see FIG. 9B). During the vision inspection, the first edge slots 234 of the first stationary supporter 230 wait at the avoidance position. For example, after the vision inspection, the first rotational transition support 210 may perform the origin operation as needed. When the vision inspection is complete, the first gate door 128 is opened.

As described above, according to the present exemplary embodiment, the alignment inspection operation and the vision inspection operation are carried out in the state where the pre-treatment substrate W2 and the post-treatment substrate W1 being placed on the same first rotational supporter 210.

Meanwhile, during the alignment inspection operation, the internal pressure of the upper space 122 may be switched from normal pressure to a preset vacuum pressure, and during the vision inspection operation, the internal pressure of the upper space 122 may be switched from a preset vacuum pressure to normal pressure.

According to the exemplary embodiment of the present invention, in the load lock chamber 40, which is located on the transfer path of the pre-treatment substrate W2, which is scheduled for treatment, and the post-treatment substrate W1, which has completed treatment, the notch and surface inspection of the substrate W may be performed. This means that the substrate W2 may be inspected for notches, alignment, and the surface treatment condition of the substrate W1 in the load lock chamber 40. Accordingly, the movement path of the substrate in the substrate treating apparatus 1 may be minimized. Accordingly, the transfer sequence of the substrates W1 and W2 may be simplified so that the substrates may be treated efficiently.

The foregoing detailed description illustrates the present invention. Further, the above content illustrates and describes the exemplary embodiment of the present invention, and the present invention can be used in various other combinations, modifications, and environments. That is, the foregoing content may be modified or corrected within the scope of the concept of the invention disclosed in the present specification, the scope equivalent to that of the invention, and/or the scope of the skill or knowledge in the art. The foregoing exemplary embodiment describes the best state for implementing the technical spirit of the present invention, and various changes required in the specific application field and use of the present invention are possible. Accordingly, the detailed description of the invention above is not intended to limit the invention to the disclosed exemplary embodiment. Further, the accompanying claims should be construed to include other exemplary embodiments as well.

## Claims

1. An apparatus for treating a substrate, the apparatus comprising:
an equipment front end module including a first transfer robot for transferring a substrate;
a transfer chamber including a second transfer robot for transferring a substrate; and
a load lock chamber disposed on a transfer path along which a substrate is transferred between the transfer frame and the transfer chamber,
wherein the load lock chamber includes:
a housing including an upper chamber having an upper space, and a lower chamber positioned below the upper chamber and having a lower space;
a first rotational supporter for supporting and rotating a substrate located in the upper space; and
a second rotational supporter for supporting and rotating a substrate located in the lower space, and
the first rotational supporter and the second rotational supporter are used for both an alignment inspection of a substrate and a vision inspection of a substrate.

2. The apparatus of claim 1, further comprising:
a first stationary supporter for supporting the substrate in the upper space; and
a second stationary supporter for supporting the substrate in the lower space,
wherein the first rotational supporter is rotated by a first rotation driving part and lifted by a first lifting driving part,
the second rotational supporter is rotated by a second rotation driving part, and
the second stationary supporter is lifted by a second lifting driving part.

3. The apparatus of claim 2, wherein the first stationary supporter includes:
first support shafts provided at an edge of the upper space; and
first edge slots connected to each of the first support axes, respectively, and supporting a lower edge of the substrate, and
the apparatus further includes a third rotation driving part for pivoting the first support shafts such that the first edge slots are pivoted from a position capable of supporting the substrate to an avoidance position having no interference during rotating and lifting operations of the first rotational supporter.

4. The apparatus of claim 2, wherein the second stationary supporter includes:
second support shafts provided at an edge of the lower space; and
second edge slots connected to the second support shafts, respectively, and supporting a lower edge of the substrate.

5. The apparatus of claim 2, wherein the first rotational supporter includes:
a first rotation shaft connected with the first rotation driving part provided above the housing;
horizontal fingers provided in the upper space, connected with the first rotation shaft, and having lengths greater than a radius of the substrate; and
support fingers provided at distal ends of the horizontal fingers and supporting a lower edge of the substrate.

6. The apparatus of claim 2, wherein the first lifting driving part includes:
a first actuator;
a first lifting bar lifted by the first actuator and connected with the first rotational supporter; and
a first guide for guiding upward and downward movement of the first lifting bar.

7. The apparatus of claim 2, wherein the second rotational supporter includes:
a second rotation shaft connected with the second rotation driving part provided in a lower portion of the housing; and
a support plate provided in the lower space, connected to the second rotation shaft, smaller than a radius of the substrate, and supporting a center portion of a bottom surface of the substrate.

8. The apparatus of claim 2, further comprising:
a third stationary supporter provided at a floor surface of the upper space, and supporting the substrate,
wherein the substrate is picked up and placed on the third stationary supporter by an up/down operation of the first rotational supporter.

9. The apparatus of claim 2, wherein a center of rotation of the first rotational supporter and a center of rotation of the second rotational supporter are provided to be different,
an alignment inspection and vision inspection position in the first rotational supporter and an alignment inspection and vision inspection position in the second rotational supporter are provided positions where the substrate placed on the first rotational supporter and the substrate placed on the second rotational supporter do not overlap each other when viewed from above.

10. The apparatus of claim 9, further comprising:
a first alignment unit for aligning a substrate located in the upper space;
a second alignment unit for aligning a substrate located in the lower space;
a first vision unit for inspecting an edge surface condition of a substrate located in the upper space; and
a second vision unit for inspecting an edge surface condition of a substrate located in the lower space.

11. The apparatus of claim 10, wherein the first alignment unit, the second alignment unit, the first vision unit, and the second vision unit are provided above the housing.

12. The apparatus of claim 9, wherein a partition wall between the upper chamber and the lower chamber is provided with a viewing window for the alignment inspection and the vision inspection of the substrate located in the lower space.

13. A method of inspecting a substrate in a load lock chamber located between an equipment front end module and a transfer chamber, the method comprising:
a first loading operation in which a pre-treatment substrate is loaded from the equipment front end module and a post-treatment substrate is unloaded to the equipment front end module;
a second loading operation in which a post-treatment substrate is loaded from the transfer chamber and the pre-treatment substrate is unloaded to the transfer chamber;
an alignment inspection operation in which an alignment inspection of the pre-treatment substrate is performed prior to the second loading operation; and
a vision inspection operation in which a vision inspection of the post-treatment substrate is performed prior to the first loading operation,
wherein the alignment inspection operation and the vision inspection operation are performed in a state where the pre-treatment substrate and the post-treatment substrate are placed on the same rotational supporter.

14. The method of claim 13, wherein the post-treatment substrate after the vision inspection on the rotational supporter is placed on a stationary supporter, the pre-treatment substrate is placed on the rotational supporter in the first loading operation, the pre-treatment substrate placed on the stationary supporter is placed on the rotational supporter and then subjected to the alignment inspection in the alignment inspection operation.

15. The method of claim 13, wherein the post-treatment substrate is placed on the stationary supporter in the second loading operation, and the post-treatment substrate placed on the stationary supporter is placed on the rotational supporter and subjected to the vision inspection in the vision inspection operation.

16. The method of claim 13, wherein the alignment inspection operation includes
performing an origin operation to pivot the rotational supporter to an origin position after finishing the alignment of the pre-treatment substrate, and
the origin operation of the rotational supporter is accomplished after the pretreatment substrate is placed on a stationary supporter installed on a floor of an interior space of the load lock chamber.

17. The method of claim 13, wherein during the alignment inspection operation, an internal pressure of the load lock chamber is switched from normal pressure to a preset vacuum pressure, and
during the vision inspection operation, the internal pressure of the load lock chamber is switched from the preset vacuum pressure to the normal pressure.

18. An apparatus for treating a substrate, the apparatus comprising:
a housing including an upper chamber having an upper space, and a lower chamber positioned below the upper chamber and having a lower space;
a first rotational supporter for supporting and rotating a substrate located in the upper space;
a second rotational supporter for supporting and rotating a substrate located in the lower space;
a first stationary supporter for supporting a substrate in the upper space;
a second stationary supporter for supporting a substrate in the lower space;
a first alignment unit for aligning a substrate located in the upper space;
a second alignment unit for aligning a substrate located in the lower space;
a first vision unit for vision-inspecting a substrate located in the upper space; and
a second vision unit for vision-inspecting a substrate located in the lower space,
wherein the first alignment unit, the second alignment unit, the first vision unit, and the second vision unit are provided above the housing, and
the first rotational supporter and the second rotational supporter are used for both an alignment inspection of the substrate and a vision inspection of the substrate.

19. The apparatus of claim 18, wherein the first rotational supporter is rotated by a first rotation driving part and lifted by a first lifting driving part,
the second rotational supporter is rotated by a second rotation driving part, and
the second stationary supporter is lifted by a second lifting driving part, and
the first stationary supporter includes:
first support shafts provided at an edge of the upper space; and
first edge slots connected to each of the first support axes, respectively, and supporting a lower edge of the substrate, and
the apparatus further includes:
a third rotation driving part for pivoting the first support shafts such that the first edge slots are pivoted from a position capable of supporting the substrate to an avoidance position having no interference during rotating and lifting operations of the first rotational supporter; and
a second stationary supporter provided on a floor surface of the upper space and supporting the substrate, and
the substrate is picked up and placed on the second stationary supporter by an up/down operation of the first rotational supporter.

20. The apparatus of claim 18, wherein a center of rotation of the first rotational supporter and a center of rotation of the second rotational supporter are provided to be different,
an alignment inspection and vision inspection position in the first rotational supporter and an alignment inspection and vision inspection position in the second rotational supporter are provided at positions where the substrate placed on the first rotational supporter and the substrate placed on the second rotational supporter do not overlap each other when viewed from above, and
a partition wall between the upper chamber and the lower chamber is provided with a viewing window for the second alignment unit and the second vision unit.
